# EUROPEAN PATENT SPECIFICATION

(11) **EP 1 111 903 B1**
(45) Date of publication and mention of the grant of the patent: **21.04.2010**
(21) Application number: 00125345.9
(22) Date of filing: 30.11.2000
(51) Int. Cl.: H04N 1/40

(54) **An optical writing apparatus and method**
Optisches Schreibgerät und -Verfahren
Dispositif et procédé d'écriture optique

(30) Priority: 30.11.1999 JP 34125299
(43) Date of publication of application: 27.06.2001
(73) Proprietor: Ricoh Company, Ltd., Tokyo 143-8555 (JP)
(72) Inventor: Ikeda, Yoshito, Ohta-ku, Tokyo 143-8555 (JP)
(74) Representative: Schwabe, Hans-Georg

(56) References cited:
- EP-A- 0 710 005
- EP-A- 0 902 586
- US-A- 4 796 265
- US-A- 5 892 219

## Description

### BACKGROUND OF THE INVENTION

### Field of the Invention

The present invention relates to a multiple beam optical writing apparatus according to the preamble of claim 1 and method according to claim 3 employed in an image forming apparatus such as laser printer, digital copying machine, facsimile device, etc., in particular, a multiple beam optical writing apparatus and method in which an optical writing operation is performed by use of a semiconductor laser (laser diode) array.

### Discussion of the Background

Hitherto, in an image forming apparatus such as a digital copying machine, etc., an optical writing apparatus has been used provided with a single laser chip comprising a light-emitting element (semiconductor laser) and a light-receiving element (photodiode) and a semiconductor laser drive controlling circuit (semiconductor laser drive controlling device) for driving the light-emitting element in the laser chip and causing the light-emitting element to perform the writing operations in line, i.e. line per line.

In such an optical writing apparatus, the laser beam emitted from the light-emitting element in the single laser chip is periodically deflected by use of a polygon mirror rotated by a polygon mirror. The surface of the photosensitive body rotated in the sub-scanning direction is scanned in the main scanning direction, and the image is written on the surface thereof.

In the semiconductor laser (hereinafter, called "LD") drive controlling circuit, one system of negative feedback loop is connected to one laser chip. Namely, a light-receiving signal is outputted from the light-receiving element corresponding to the light-emitting level or intensity of emitted light detected by the light-receiving element. An APC operation is performed such that the amount or intensity of light emitted by the light-emitting element is controlled to a constant value in accordance with the light-receiving signal outputted from the light-receiving element in the one laser chip, said signal corresponding to the light-emitting level of or to the level of light emission from the light-emitting element. To state concretely, the normal-direction current flowing through the light-emitting element is controlled so as to respectively equalize the light-receiving signal outputted from the light-receiving element corresponding to the light-emitting level of the light-emitting element.

In recent years, the demand for higher print speeds (image forming speed), and the demand for high quality images formed, etc. has increased. A high-speed rotation of the polygon motor and a high image frequency has been realized. However, there are respectively limitations in the speeding-up of those factors. In addition, it has become further difficult technically day by day to realize the above matters.

In order to cope with these problems, the speeding-up of those factors has been put forward by utilizing an optical writing apparatus using multiple beams (multiple laser beams). As an example for such a multiple beam device, there exists an optical writing apparatus provided with plural laser chips and plural LD drive controlling circuits for simultaneously driving respectively the light-emitting elements in the respective laser chips and causing the light-emitting elements to perform the optical writing operation such that plural lines are written each time the surface of the photosensitive body is scanned. In such a structure, the images of the plural lines are simultaneously written on the surface of the photosensitive body.

In such an optical writing apparatus, the laser beams emitted from the light-emitting elements in the respective laser chips are respectively deflected periodically by use of a polygon mirror, in particular a single polygon mirror, rotated by the polygon motor. Due to the use of plural laser chips, a positional difference is caused in the sub-scanning direction on the surface of the photosensitive body between the plural laser beams emitted by the plural laser chips, said photosensitive body being rotated in the sub-scanning direction, and the surface thereof being scanned in the main scanning direction. According to this apparatus an image is written on the surface of the photosensitive body by use of multiple beams.

According to this method of writing an image by use of multiple beams, the size of the image which can be written at the same time is increased, and thereby the revolutions (number) of the polygon motor and the image frequency can be reduced. Consequently, the image can be processed stably and with high speed.

In this method of writing an image by use of the aforementioned multiple beams, if the print speed is to be increased further and if the image quality is to be improved further, the number of laser chips has to be increased. However, in such a case the structural parts, in particular their stability, may become further complicated in order to adjust the pitch in the sub-scanning direction of the light-emitting point of the light-emitting elements in the respective laser chips accurately and stably. Furthermore, it is necessary in such a case to further increase the speed of the synchronization detecting plate (synchronization detecting sensor) generating and outputting a synchronization detecting signal for prescribing or defining the writing starting position (image starting position) in the main scanning direction by the image signal of each channel (CH) for modulating and driving (lighting up/putting out) the respective light-emitting elements.

Furthermore, in order to further increase the printing speed and to further improve the image quality, there has been already proposed to use an LD array (semiconductor laser array), which is a laser chip constructed with plural light-emitting elements and a single light-receiving element.

As the characteristic of the LD array, the plural light-emitting elements are arranged in the main scanning direction (on almost same position in the main scanning direction) and are arranged with a predetermined pitch (at equal intervals). Since the adjustment between the pitches of the light-emitting points of the light-emitting elements or the multiple laser beams on the surface of the photosensitive body is determined by the property of the lens in the optical system, it may be possible to omit the complicated adjustment mechanism for adjusting the rotation, etc.

Furthermore, since the plural light-emitting elements are arranged in a row in the main scanning direction, the synchronization detecting signal of either one of the channels (CH) outputted from the synchronization plate can be commonly used. Therefore, it is not necessary to control the phase between the respective channels (CH). Consequently, the problem to be solved of the synchronization detecting plate, that is, the problem of the response speed thereof can be eliminated.

US-A-5,892,219 discloses an optical writing apparatus according to the preamble of claim 1; wherein a timing signal generating circuit generates signals to be applied to different switches while no timing control is provided which is accomplished by means of an APC sensor. Accordingly, switching delays between the different switches may occur.

### SUMMARY OF THE INVENTION

Heretofore, the background arts regarding the optical writing apparatus have been described. However, according to this prior art, there exists no advantageous functional effect for improving the above-mentioned optical writing apparatus.

The present invention has been made in view of the above-discussed and other problems and is to solve the above-mentioned defects and troublesome matters of the background arts.

To state in more detail, a primary object of the present invention is to provide an optical scanning apparatus improving the defects and troublesome matters of the background arts. Since the LD array takes (adopts) a peculiar structure, being composed of plural light-emitting elements and a single light-receiving element, there exists no LD drive controlling circuit exclusively used for the LD array. For this reason, when the LD array is employed, it is necessary to construct the control circuit in a discrete state.

Moreover, at the present time, LD arrays of the cathode-common type are commonly used. Furthermore, as the LD drive controlling circuit of the cathode-common type LD of 1 CH (LD driver for use in 1 CH), many ICs including the APC function block (circuit for performing the APC operation) have been proposed up to now.

The present invention has been made in consideration of the above-mentioned matters. In the optical writing apparatus, the LD array can be driven by use of a commonly-used existing LD drive controlling circuit such as the LD driver for use in 1 CH (including the APC function block).

As mentioned heretofore, it is another primary object of the present invention to simplify the entire control circuit, stabilize the LD driving by use of the LD driving IC (exclusively-used IC), and reduce the cost thereof.

In order to attain the aforementioned objects of the present invention, the invention relates to a multiple beam optical writing apparatus comprising the features referred to in claim 1.

Furthermore, the invention is directed to a method according to claim 3.

### BRIEF DESCRIPTION OF THE DRAWINGS

A more complete appreciation of the present invention and many of the attendant advantages thereof will be readily obtained as the same becomes better understood by reference to the following detailed description when considered in connection with the accompanying drawings, wherein:
Fig. 1 is a circuit diagram for illustrating the structure example of the optical writing apparatus (writing unit) relating to the present invention in the printer section 10 shown in Fig. 2;
Fig. 2 is a block diagram for illustrating the main part of the digital copying machine comprising an optical writing apparatus of the embodiment according to the present invention;
Fig. 3 is a block diagram for illustrating the structure example of GAVD11 shown in Fig. 1;
Fig. 4 is a block diagram for illustrating the structure example of the output data controlling section 73 shown in Fig. 3;
Fig. 5 is a timing chart for illustrating the operation example relating to the present invention in the printer section 10 shown in Fig. 2;
Fig. 6 is a block diagram for illustrating the structure example of the combination circuit for creating the SW (switching) changing-over signal employed in case that the GAVD11 shown in Fig. 1 cannot create the SW changing-over signal due to the limitation of the pins number, etc.; and
Fig. 7 is a timing chart for illustrating the outputting timing example of the respective signals of the combination circuit and the GAVD11 in the case of employing the combination circuit shown in Fig. 6.

### DETAILED DESCRIPTION OF THE PREFERRED EMBODIMENT

In describing the preferred embodiment of the present invention illustrated in the accompanying drawings, specific terminology is employed for the sake of clarity. However, the present invention is not intended to be limited to the specific terminology so selected and it is to be understood that each specific element includes all technical equivalents which operate in a similar manner.

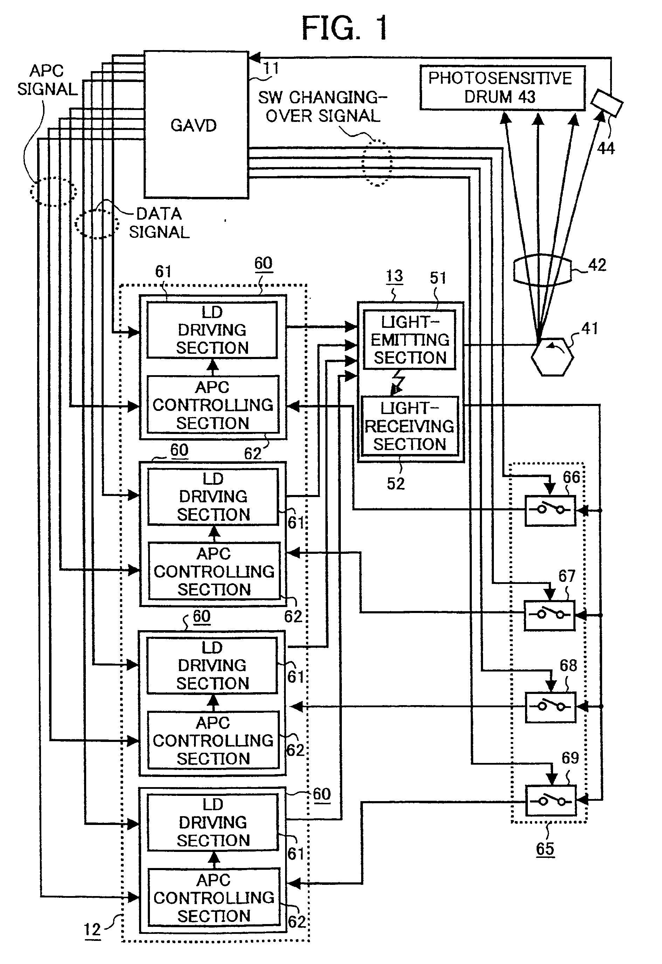

Referring now to the accompanying drawings; wherein like reference numerals designate identical or corresponding parts throughout the several views or diagrams, and more particularly to Figs. 1 through 7, there is illustrated an optical writing apparatus according to the present invention including a semiconductor laser array constructed with plural light-emitting elements and a single light-receiving element and plural semiconductor laser drive controlling devices.

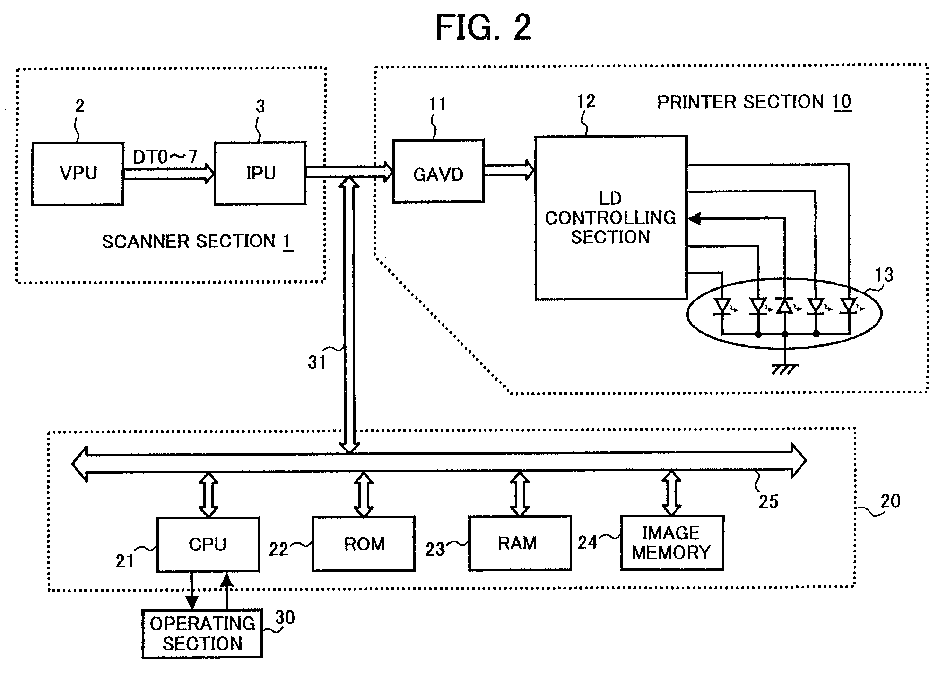

Fig. 2 is a block diagram illustrating an example of the main part structure of the digital copying machine, comprising an optical writing apparatus of the embodiment according to the present invention.

The digital copying machine is provided with a scanner section 1 for optically reading out an image of the original document, a printer section 10 for printing and outputting the image information (image signal) read out by the scanner portion 1, a main control section 20 for totally (generally) controlling the entire portion of the digital copying machine, and an operation board section 30 to which the user gives an instruction.

The scanner section 1 is provided with VPU 2 and IPU 3. The VPU 2 converts the electric signal corresponding to the original document image from the CCD sensor not shown from analog to digital. Furthermore, the VPU 2 performs black offset compensation, shading compensation, and pixel position compensation, and the same outputs the results of the above compensation as the image information. The IPU 3 practices a predetermined image processing for the image information form the VPU 2.

The printer section 10 is provided with a GAVD 11, an LD control section 12, and an LD array 13. The GAVD 11 controls the LD array 13 on the basis of the image information from the GAVD 11.

The LD array 13 accommodates plural light-emitting elements LD (in the embodiment, four elements) and a single light-receiving element in one package. The light-emitting elements emit plural laser beams (light beams) each of them being modulated in accordance with the image information. The emitted laser beams are radiated via polygon mirror 41 (Fig. 1), etc. onto the surface of the photosensitive body 43 (Fig. 1), which is charged by a charger not shown. In such a way, an electrostatic latent image is formed.

The main control section 20 is provided with CPU 21, ROM 22, RAM 23, and an image memory 24. Those sections are mutually connected to each other by a system bus 25. The scanner section 1, the printer section 10, and the main control section 20 are mutually connected to each other by the system bus 25 and an interface (I/F) section 31.

The CPU 21 is a central processing unit for totally controlling the entire portion of the main control section 20 in accordance with a control program stored in ROM 22.

The ROM 22 is a memory exclusively employed for reading out the information which memorizes the control program to be employed for the CPU 21. The RAM 23 is a memory capable of reading and writing the information which is employed as a work memory at the time of performing the data processing by use of the CPU 21. The image memory 24 is a memory capable of reading and writing which memorizes the image information from the scanner section 1 for one or plural pages.

Fig. 1 is a construction block diagram illustrating an example of the structure of the writing apparatus (writing unit) in the printer section relating to the present invention.

The plural laser beams emitted by the light-emitting section 51 of the LD array 13 are collimated by a collimator lens (not-shown). The laser beams thus collimated are periodically deflected by a deflector (light beam scanning device) 41 composed of a rotatable polygon mirror. The laser beams thus deflected are simultaneously focused on the surface of the photosensitive drum 43 uniformly charged by the not-shown charger by use of an f. lens 42. The focused light spots are repeatedly and simultaneously moved and scanned in the axis direction of the photosensitive drum 43, i.e. in the main scanning direction, by the action of the rotation of the deflector 41. The photosensitive drum 43 rotates concurrently.

Since the LD array 13 includes a light-emitting section 51 composed of four light-emitting elements, four lines of laser beam radiation having a pitch (position difference) in the sub-scanning direction (i.e. in the rotational direction of the photosensitive drum 43) are drawn simultaneously on the surface of the photosensitive drum 43.

While according to this embodiment the light-emitting section emits four light beams, this invention is not limited to this number of light beams. Accordingly, the light-emitting section may emit a different number of light beams, e.g. 2, 3 or more than 4 light beams.

In such a way, an electrostatic latent image is formed on the surface of the photosensitive drum 43 by the action of the laser beam radiation. The electrostatic latent image formed thereon is developed by toner from a developing device (not-shown), and thereby a toner image is formed. The formed toner image is transferred onto the transfer paper fed by the not-shown paper feeding device by use of a not-shown transferring device.

Since the laser beam 5, immediately before scanning the surface of the photosensitive drum 43, pass through a light detector 44 (synchronization detecting signal generating device) composed of a light-receiving element such as a photodiode, mounted e.g. outside of the main scanning writing area (outside of the predetermined main scanning width), e.g. on the photosensitive drum 43, the light detector 44 detects the laser beams, and creates and outputs a synchronization detecting signal for performing the positioning operation in the main scanning direction (namely, prescribing the position of starting the writing operation in the main scanning direction). Instead of passing through the light-receiving element, a part of the laser beams, generated e.g. by means of a beam splitter, may also be focused on the light-receiving element.

The GAVD 11 is the one for practicing the function of an outputting timing determining device according to the first through third aspect of the present invention. GAVD 11 also respectively determines the output timing of outputting four image signals (DATA signals) to the four LD drive controlling circuits 60 (semiconductor laser drive controlling devices) in the LD control section 12, the output timing of outputting the SW changing-over signal to the changing-over switch circuit 65, and the output timing of outputting the APC signal (control starting signal) to the APC controlling sections 62 of the respective LD drive controlling circuit 60. The above-mentioned respective signals are outputted with the respective timing thus determined.

The respective LD drive controlling circuits 60 respectively comprise the LD drive section 61 and the APC controlling section 62. The LD drive sections 61 in the respective LD drive controlling circuits 60 simultaneously drive the respective light-emitting elements of the light-emitting section 51 in the LD array 13 in accordance with the image signal from the GAVD 11. The LD drive sections 61 in the respective LD drive controlling circuits 60 simultaneously cause the light-emitting elements to respectively emit a laser beam. In such a way, the light writing operation per each of the plural lines is performed at the same time on the surface of the photosensitive drum 43 and thereby the electrostatic latent image is formed. The laser beam emitted backward from the light-emitting element 51 is directed as the incident light to the light-receiving section composed of the light-receiving element such as a photodiode, etc.

The light-receiving section 52 detects the light intensity (light-emitting level of the light-emitting element) of the laser beam thus directed as the incident light. The incident laser beam is the beam emitted in order from the respective light-emitting elements in the light-emitting section 51 at the time of the APC operation. The light-receiving section 51 also outputs the light-receiving signal corresponding thereto to the APC controlling section 62 of either one of the LD drive controlling circuits 60 through the changing-over switch device. Here, the APC controlling section 62 signifies the APC controlling section in the LD drive controlling circuits 60 having the LD drive section 61 which causes the corresponding light-emitting element to emit the light at this time.

The changing-over switch circuit 65 is constructed with four changing-over switches 66-69. Either one of the changing-over switches 66-69 is selectively turned on (ON state) by the switch changing-over signal from the GAVD 11. Thereby, it is possible to change over the construction of the negative feedback loop (optoelectronic negative feedback loop) of either one of the LD drive controlling circuits 60 for the light-receiving signal outputted from the light-receiving section 52 of the LD array 13.

The APC controlling section 62 in the respective LD drive controlling circuits 60 controls the LD drive section 61 in accordance with the inputted light-receiving signal, and further controls the light-emitting level of the corresponding light-emitting element in the light-emitting sections 51 of the LD arrays 13 (or the intensity of light emitted by the corresponding light-emitting element) so as to make the light-emitting level constant. Namely, the APC operation is performed. In such an APC operation, the normal-direction current flowing through the light-emitting element is controlled so as to respectively equalize the light-receiving signals to be inputted (corresponding to the light-emitting elements) to the light-emitting level designating signal.

At this time, the voltage of the drive power source of the corresponding light-emitting element in the LD array 13 is adjusted and held such that the light-emitting level becomes constant, namely, the corresponding light-receiving signal and the light-receiving level are respectively equalized.

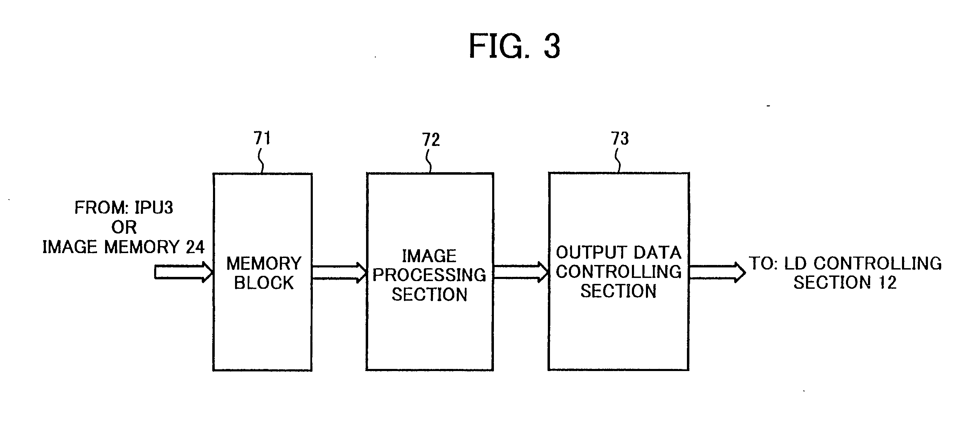

Fig. 3 is a block diagram for illustrating the structural example of the GAVD 11. The GAVD 11 is provided with a memory block 71 for practicing the speed conversion and the format conversion for the data (image signal) from the IPU 3 or the image memory 24, an image processing section 72 for practicing the predetermined image processing for the data from the memory block 71, and an output data controlling section 73 for practicing the processes such as the conversion and the P sensor pattern applying, etc.

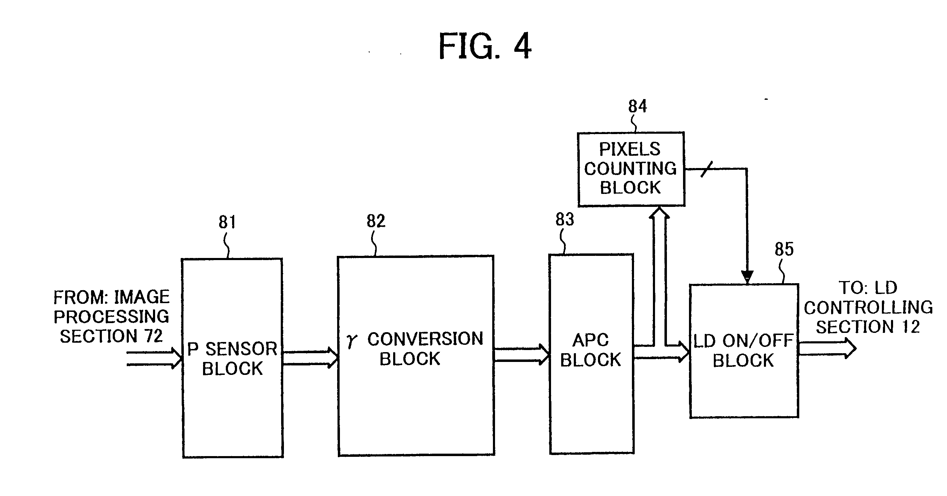

Fig. 4 is a block diagram illustrating the structural example of the output data controlling section 73 as shown in Fig. 3. In Fig. 4, the output data controlling section 73 is provided with a P sensor block 81 for applying a P sensor pattern for putting the toner of a predetermined constant density on the photosensitive drum 43 for the purpose of acquiring the data for determining the processing condition to the data inputted from the image processing section 72, and γ-conversion block 82 for causing the weight of the data to vary.

The output data controlling section 73 is further provided with an APC block 83 for applying the image signal in synchronism with the APC operation timing in order to keep constant the light intensity (light amount) of the laser beam emitted from the respective light-emitting elements of the light-emitting section 51 in the LD array 13, a pixel count block 84 for counting the number of light-emitting dots (light-emitting pixels) emitted from the respective light-emitting sections 51 in the LD array 13, and an LD ON/OFF block 85 for applying the light-emitting data for the synchronization detecting output.

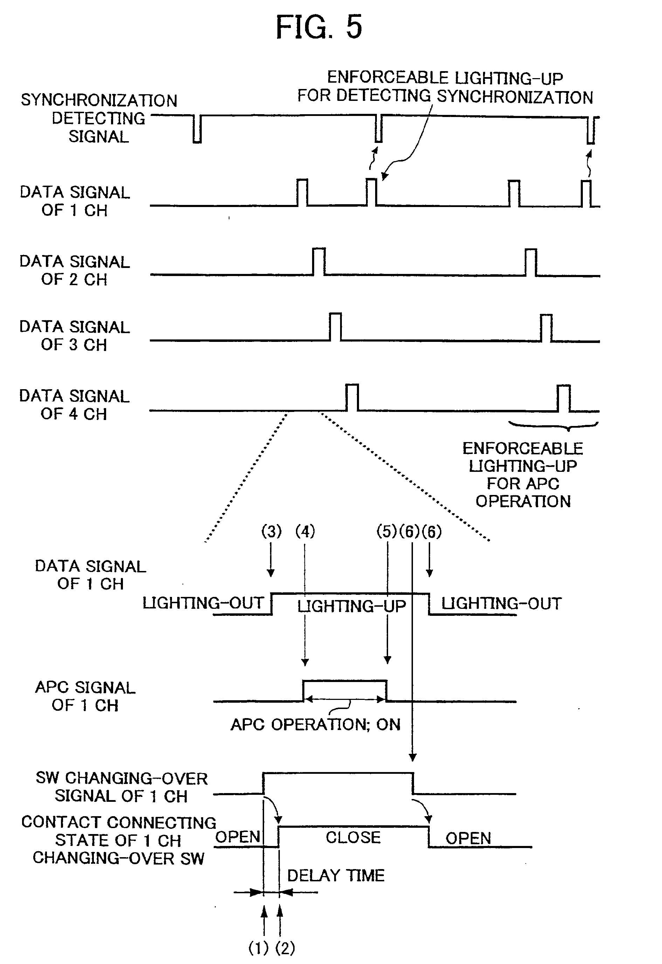

Fig. 5 is a timing chart for illustrating an example of the operation of the printer section 10 relating to the present invention. Although Fig. 5 shows the APC operation during the time period of waiting, the timing of the APC operation does not change at all, even during the time period of printing (image formation). In this exemplary embodiment, the APC operation is performed for the 4 CH light-emitting elements (four-pieces LD) per one main scanning operation.
(1) When the APC operation is performed for either one of the light-emitting elements (in the embodiment, 1-CH light-emitting element) among all respective light-emitting elements in the light-emitting section 51 of the LD array 13, the GAVD 11 in the printer section 10 forms a negative feedback loop. In such a structure, the switch changing-over signal is outputted to the 1-CH changing-over switches SW66 in order to perform the changing-over operation. At this time, the changing-over switch SW66 is turned on (ON state)
(2) In the embodiment of the present invention, since an analog switches are employed as the changing-over switches SW66-69, after the GAVD 11 outputs the switch changing-over signal to the changing-over switch SW66, the changing-over switch SW66 is closed (SW is put in the ON state) when the operational delay time (about 150ns) of the changing-over switch SW66 has elapsed from that time point. At this time, an actual negative feedback loop is constructed by the light-receiving signal outputted from the light-receiving section 32 in the LD array 13.
(3) Before the APC signal is outputted to the APC control section 62 of the 1 CH LD drive controlling circuit 60 (the circuit 60 causes the APC control section 62 to start the APC operation.), the image signal (DATA signal) employed for operating the APC action is outputted to the LD drive section 61 in the LD drive controlling circuit 60. At this time, the LD drive controlling circuit 60 outputs the image signal (DATA signal) for use in the APC operation, to the LD drive section 61 in the LD drive control circuit 60, and starts the enforceable lighting-up of the 1 CH light-emitting element of the light-emitting section 51 in the LD array 13.
(4) The enforceable lighting-up of the 1 CH light-emitting element is started , and after the negative feedback loop is formed by the action of the changing-over operation of the changing-over switch circuit 65 (after at least the time corresponding to the operational delay time of the changing-over switch 66 has elapsed), the APC signal (control starting signal) is outputted to the APC control section 62 in the 1 CH LD drive control circuit 60, and the APC operation is started at this time. This is the processing according to the first and third aspect of the present invention.
(5) The outputting operation of outputting the APC signal to the APC control section 62 in the 1 CH LD drive controlling circuit 60 is stopped. At this time, the APC controlling section 62 causes the APC operation to finish.
(6) After finishing the APC operation by use of the APC controlling section 62 in the 1 CH LD drive controlling circuit 60, the outputting of the switch changing-over signal to the changing over switch SW66 of the changing-over switch circuit 65 is stopped at this time, and the changing-over switch SW66 is turned off (put in the open state), namely, the negative feedback loop is released. In addition, the outputting of the image signal (DATA signal) for the APC operation to the APC controlling section 62 in the 1 CH LD drive controlling circuit 60 is stopped, and the enforceable lighting-up of the 1 CH light-emitting element in the light-emitting section 51 of the LD array 13 is released. This is the processing according to the second and third aspect of the present invention.

Moreover, in the embodiment of the invention, the timing of outputting the above-mentioned respective signals by use of the GAVD 11 is cleared by the synchronization detecting signal employed in the GAVD 11. The same outputting timing is created by use of a not-shown main scanning counter, in which the counting-up operation is performed by the writing clock CLK.

As the actual operation, when the count values previously reach some given value, the state of whether the respective signals are outputted (the signals are respectively turned on) or the outputting of the respective signals is stopped ( the signals are respectively turned off) has been selectively set in advance, and in such the setting, the outputting or stopping of the respective signals is selectively performed by comparing the aforementioned count values with those respective values of the above setting.

Those setting values can be changed at the time of setting the various setting data to a special (peculiar) mode capable of changing the setting data which is called the SP (Service-man Program) Mode, by use of the operation signal from the operation board section 30.

In the embodiment of the present invention, although the analog switches are respectively employed as the changing-over switches SW66-69 constructing the changing-over switch circuit 65 any (switching) parts, in particular digital switching parts, may be used if such parts are capable of optionally opening/closing the contacts of the relay, etc. However, since the delay times are different from each other according to the parts employed, it is necessary to prepare the setting data of the operational timing fitted to the parts employed.

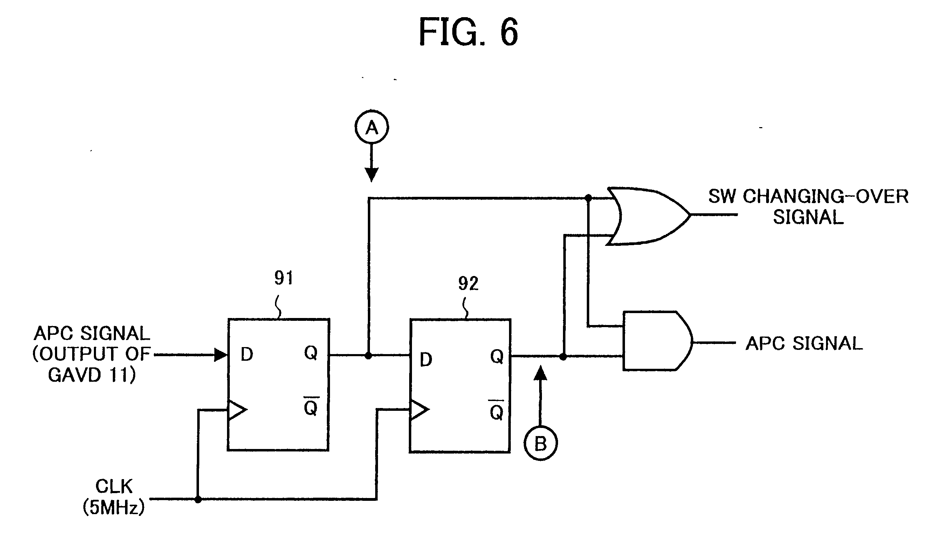

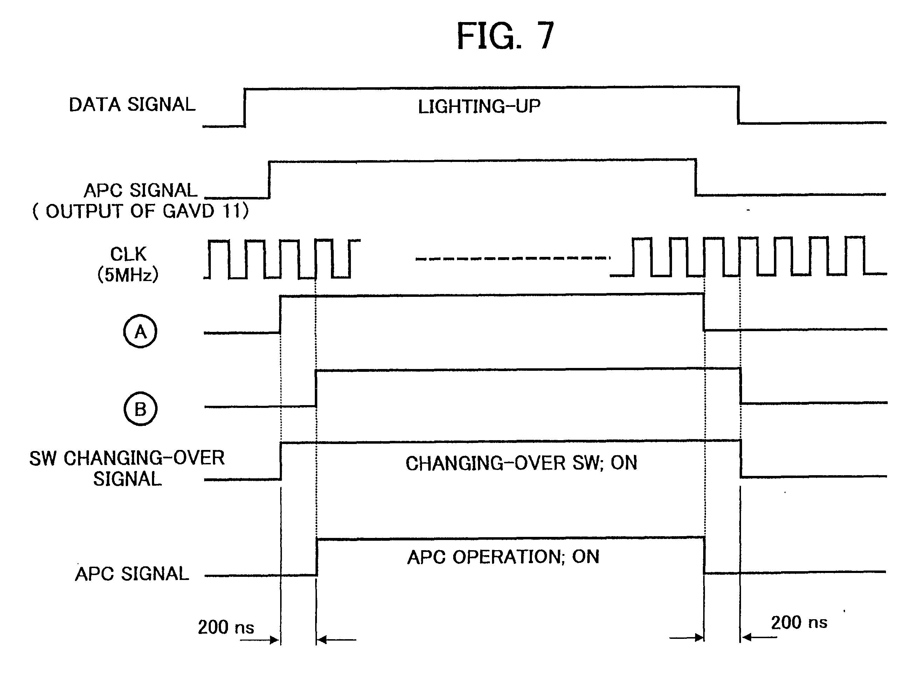

Furthermore, in the same embodiment, it is necessary to separately prepare the switch changing-over signals both for the image signal (DATA signal) and the APC signal. However, in case that the GAVD 11 cannot create the switch changing-over signal because of the limitation of the pins number, etc., as shown in Fig. 6 for example, the APC signal and the switch changing-over signal can be newly created separately from the APC signal by providing a combination of plural digital circuits including two flip-flop circuits 91 and 92. Fig. 7 shows an example of the outputting timing of the respective signals in the GAVD 11 and the above-mentioned combination circuit.

So far, it has been described that the embodiment according to the present invention may be applied to the optical writing apparatus (employing an LD array) of a digital copying machine. However, the present invention is not limited to such an embodiment. The invention is also applicable to any other type of optical writing apparatus (employing the LD array) using an electrophotographic image forming method, such as laser printer, facsimile device, etc.

As described heretofore, according to the optical writing apparatus of the first and third aspect of the invention, the apparatus is provided with a changing-over switch device capable of changing over either one of the semiconductor laser drive controlling devices (commonly-used LD drive controlling circuits including the APC function). The light-receiving signal outputted from the light-receiving element of the semiconductor laser array is constructed as a negative feedback loop of either one of the semiconductor laser drive controlling devices. The apparatus is further provided with an outputting timing determining device for respectively determining the timing of outputting the changing-over signal to the changing-over switch device and the timing of outputting the control starting signal to the current controlling device of the respective semiconductor laser drive controlling device. In such a structure, the LD drive controlling circuit (LD driver) including the commonly-used APC function can be used. By employing an LD drive IC, the entire control circuit can be simplified further. Accordingly the base board carrying the entire control circuit can be small-sized, and the negative feedback loop can be shortened. Consequently, the respective light-emitting elements of the semiconductor laser array can perform a further stable drive operation.

The outputting timing determining device outputs a changing-over signal to the changing-over switch device. After at least a time period corresponding to the operational delay time of the changing-over switch device has elapsed since that timing, the outputting timing determining device further outputs a control starting signal to the current controlling device (portion of performing the APC operation) of the semiconductor laser drive controlling device, which is connected to the negative feedback loop formed by the changing-over action of the changing-over switch device. In such a structure, it is possible to avoid that the APC operation is performed on the occurrence of the condition that the light-receiving signal (feedback current) is cut off or intercepted. Consequently, an excessive light emission from the light-emitting element can be prevented.

As described heretofore, according to the optical writing apparatus of the second aspect of the invention, the apparatus is provided with a changing-over switch device capable of changing over either one of the semiconductor laser drive controlling devices (commonly-used LD drive controlling circuits including the APC function). The light-receiving signal outputted from the light-receiving element of the semiconductor laser array is constructed as a negative feedback loop of either one of the semiconductor laser drive controlling devices. The apparatus is further provided with an outputting timing determining device for respectively determining the timing of outputting the changing-over signal to the changing-over switch device and the timing of outputting the control starting signal to the current controlling device of the respective semiconductor laser drive controlling device. In such a structure, an LD drive controlling circuit (LD driver) including a commonly-used APC function can be used. By employing an LD drive IC, the entire control circuit can be simplified further. Accordingly the base board carrying the entire control circuit can be small-sized, and the negative feedback loop can be shortened. Consequently, the respective light-emitting elements of the semiconductor laser array can perform a further stable drive operation.

Furthermore, after finishing the control operation performed by the current controlling device in the semiconductor laser drive controlling device connected to the negative feedback loop formed by the changing-over action of the changing-over switch device among the current controlling device (portion of performing the APC operation) of the respective semiconductor laser drive controlling devices, the outputting timing determining device stops the outputting of the changing-over signal to the changing-over switch device. As a result, it is possible to avoid that the light-receiving signal (feedback current) from the light-receiving element is cut off (intercepted) during the time period of the APC operation. Consequently, an excessive light-emission from the light-emitting element can be prevented.

According to the optical writing apparatus of the third aspect of the invention, the outputting timing determining device performs the same controlling operation as that of the first aspect of the invention. In addition, after finishing the control operation performed by the current controlling device in the semiconductor laser drive controlling device connected to the negative feedback loop formed by the changing-over action of the changing-over switch device among the current controlling device (portion of performing the APC operation) of the respective semiconductor laser drive controlling devices, the outputting timing determining device stops the outputting of the changing-over signal to the changing-over switch device. As a result, it is possible to avoid that the light-receiving signal (feedback current) from the light-receiving element is cut off (intercepted) during the time period of the APC operation. Consequently, an excessive light emission from the light-emitting element can be prevented.

Preferred embodiments of the present invention (the first through third aspects) have been described heretofore. However, the invention is not limited to the above-mentioned embodiment (aspects). Numerous additional modifications and variations of the present invention are possible in light of the above teachings. It is therefore to be understood that, within the scope of the appended claims, the present invention may be practiced otherwise than specifically described herein.

## Claims

1. A multiple beam optical writing apparatus comprising:
a semiconductor laser array (13) comprising plural light-emitting elements (51) and a single light-receiving element (52); and
a plurality of semiconductor laser drive controlling devices (61) respectively and simultaneously driving said plural light-emitting elements (51) in said semiconductor laser array (13) and thereby causing said light-emitting elements to perform an optical writing operation at the same time for each of a plurality of lines,
wherein each of said plurality of semiconductor laser drive controlling devices comprises:
a current controlling device (60, 62) controlling the normal-direction currents flowing through said respective plural light-emitting elements (51) such that light-receiving signals which correspond to the light-emitting levels of said respective light-emitting elements and are outputted from said light-receiving element (52) in said semiconductor laser array (13), and light-emitting level designating signals respectively become equal to each other;
wherein said optical writing apparatus further comprising:
a change-over switching device (65, 66, 67, 68, 69) capable of changing over said plural semiconductor laser drive controlling devices to either one of them as a negative feedback loop, to which the light-receiving signal is output from said light-receiving element (52) in said semiconductor laser array; and
an outputting timing determination device (11) respectively determining an output timing of outputting a change-over signal to said change-over switching device (65, 66, 67, 68, 69) and another output timing of outputting the control starting signal to said current controlling device in said respective semiconductor laser drive controlling devices (61);
a synchronization detector (44) detecting the semiconductor laser light when starting in the main scanning direction on the photosensitive member (43), and generating a synchronization detecting signal;
**characterized by**
said outputting timing determination device (11) further comprising:
an output delaying device which is configured for outputting change-over signals,after time delay periods corresponding at least to the operational delay time or times of said change-over switching device (65) have elapsed, to said change-over switching device (65) and outputting corresponding control starting signals to said current controlling devices in said semiconductor laser drive controlling devices (61) connected to said negative feedback loop formed by the changing-over operation of said change-over switching device, and
wherein said outputting timing determination device (11) is configured to determine the outputting timings according to the synchronization detecting signal generated by said synchronization detector (44).

2. The optical writing apparatus as defined in claim 1, wherein said outputting timing determination device (11) further comprises:
an outputting stopping device stopping the outputting of the change-over signal to said change-over switching device (65, 66, 67, 68, 69), after finishing the control operation by use of said current controlling device (60, 62) in said semiconductor laser drive controlling device (61) connected to the negative feedback loop formed by the changing-over operation of said change-over switching device among said current controlling devices in said respective semiconductor laser drive controlling devices.

3. A method of writing an image with a multiple optical beam comprising:
preparing a semiconductor laser array (13) comprising plural light-emitting elements (51) and a single light-receiving element (52); and
respectively and simultaneously driving said plural light-emitting elements (51) in said semiconductor laser array (13) and thereby causing said light-emitting elements to perform an optical writing operation at the same time for each of a plurality of lines, by using of plural semiconductor laser drive controlling devices (61);
wherein each of said plurality of semiconductor laser drive controlling devices conducts the steps of:
controlling the normal-direction currents flowing through said respective plural light-emitting elements (51) such that the light-receiving signals, which correspond to the light-emitting levels of said respective light-emitting elements and are outputted from said light-receiving element (52) in said semiconductor laser array (13), and the light-emitting level designating signals respectively become equal to each other by using a current controlling device;
changing over said plural semiconductor laser drive controlling devices to either one of them as a negative feedback loop, to which the light-receiving signal is outputted from said light-receiving element in said semiconductor laser array by using a change-over switching device;
respectively determining an output timing of outputting a change-over signal to said change-over switching device (65, 66, 67, 68, 69) and another output timing of outputting the control starting signal to said current controlling device in said respective semiconductor laser drive controlling devices (61) using an outputting timing determination device (11);
detecting the semiconductor laser light when starting in the main scanning direction on the photosensitive member (43), and generating a synchronization detecting signal by using a synchronization detector (44);
**characterized by**
outputting change-over signals, after time delay periods corresponding at least to the operational delay time or times of said change-over switching device (65) have elapsed,to said change-over switching device (65) and outputting corresponding control starting signals to said current controlling devices in said semiconductor laser drive controlling devices (61) connected to said negative feedback loop formed by the changing-over operation of said change-over switching device by using an output delaying device of said outputting timing determination device (11), and
determining the outputting timings according to the synchronization detecting signal generated by said synchronization detector (44) by means of said outputting timing determination device (11).

4. The method of optically writing the image as defined in claim 3 further comprising the step of:
stopping the outputting of the change-over signal to said change-over switching device, after finishing the control operation by use of said current controlling device in said semiconductor laser drive controlling device connected to the negative feedback loop formed by the changing-over operation of said change-over switching device among said current controlling devices in said respective semiconductor laser drive controlling devices.

## Patentansprüche

1. Optische Mehrfachstrahl-Schreibvorrichtung, die umfasst:
eine Halbleiterlaser-Anordnung (13), die mehrere lichtemittierende Elemente (51) und ein einziges Lichtempfangselement (52) enthält; und
mehrere Halbleiterlaser-Ansteuerungsvorrichtungen (61), die jeweils und gleichzeitig die mehreren lichtemittierenden Elemente (51) in der Halbleiterlaser-Anordnung (13) ansteuern und dadurch die lichtemittierenden Elemente dazu veranlassen, eine Operation des optisches Schreibens gleichzeitig für jede von mehreren Zeilen auszuführen,
wobei jede der mehreren Halbleiterlaser-Ansteuerungsvorrichtungen umfasst:
eine Stromsteuervorrichtung (60, 62), die die Ströme in Normalrichtung, die durch die jeweiligen mehreren lichtemittierenden Elemente (51) fließen, in der Weise steuern, dass Lichtempfangssignale, die den Lichtemissionspegeln der jeweiligen lichtemittierenden Elemente entsprechen und von dem Lichtempfangselement (52) in der Halbleiterlaser-Anordnung (13) ausgegeben werden, und Lichtemissionspegel-Angabesignale jeweils aneinander angeglichen werden;
wobei die optische Schreibvorrichtung ferner umfasst:
eine Umschalt-Schaltvorrichtung (65, 66, 67, 68, 69), die die mehreren Halbleiterlaser-Ansteuerungsvorrichtungen zu irgendeiner von ihnen als eine negative Rückkopplungsschleife, zu der das Lichtempfangssignal von dem Lichtempfangselement (52) in der Halbleiterlaser-Anordnung ausgegeben wird, umschalten kann; und
eine Ausgabezeitpunkt-Bestimmungsvorrichtung (11), die jeweils einen Ausgabezeitpunkt zum Ausgeben eines Umschaltsignals zu der Umschalt-Schaltvorrichtung (65, 66, 67, 68, 69) und einen weiteren Ausgabezeitpunkt zum Ausgeben des Steuerstartsignals zu der Stromsteuervorrichtung in den jeweiligen Halbleiterlaser-Ansteuerungsvorrichtungen (61) bestimmt;
einen Synchronisationsdetektor (44), um das Halbleiterlaserlicht zu detektieren, wenn in der Hauptabtastrichtung auf dem lichtempfindlichen Organ (43) gestartet wird, und um ein Synchronisationsdetektionssignal zu erzeugen;
**dadurch gekennzeichnet, dass**
die Ausgabezeitpunkt-Bestimmungsvorrichtung (11) ferner umfasst:
eine Ausgabeverzögerungsvorrichtung, die konfiguriert ist, um nach dem Verstreichen von Zeitverzögerungsperioden, die wenigstens der oder den funktionalen Verzögerungszeiten der Umschalt-Schaltvorrichtung (65) entsprechen, Umschaltsignale an die Umschalt-Schaltvorrichtung (65) auszugeben und um entsprechende Steuerstartsignale zu den Stromsteuervorrichtungen in den Halbleiterlaser-Ansteuerungsvorrichtungen (61), die mit der negativen Rückkopplungsschleife verbunden sind, die durch die Umschaltoperation der Umschalt-Schaltvorrichtung gebildet wird, auszugeben, und
wobei die Ausgabezeitpunkt-Bestimmungsvorrichtung (11) konfiguriert ist, um die Ausgabezeiten in Übereinstimmung mit dem durch den Synchronisationsdetektor (44) erzeugten Synchronisationsdetektionssignal zu bestimmen.

2. Optische Schreibvorrichtung nach Anspruch 1, wobei die Ausgabezeitpunkt-Bestimmungsvorrichtung (11) ferner umfasst:
eine Ausgabestoppvorrichtung, um die Ausgabe des Umschaltsignals zu der Umschalt-Schaltvorrichtung (65, 66, 67, 68, 69) zu stoppen, nachdem die Steueroperation unter Verwendung jener Stromsteuervorrichtung (60, 62) in der Halbleiterlaser-Ansteuerungsvorrichtung (61) unter den Stromsteuervorrichtungen in den jeweiligen Halbleiterlaser-Ansteuerungsvorrichtungen, die mit der durch die Umschaltoperation der Umschalt-Schaltvorrichtung gebildeten negativen Rückkopplungsschleife verbunden ist, beendet worden ist.

3. Verfahren zum Schreiben eines Bildes mit mehreren optischen Strahlen, das umfasst:
Vorbereiten einer Halbleiterlaser-Anordnung (13), die mehrere lichtemittierende Elemente (51) und ein einziges Lichtempfangselement (52) enthält; und
jeweiliges und gleichzeitiges Ansteuern der mehreren lichtemittierenden Elemente (51) in der Halbleiterlaser-Anordnung (13) und dadurch Veranlassen der lichtemittierenden Elemente, eine optische Schreiboperation gleichzeitig für jede von mehreren Zeilen unter Verwendung mehrerer Halbleiterlaser-Ansteuerungsvorrichtungen (61) auszuführen;
wobei jede der mehreren Halbleiterlaser-Ansteuerungsvorrichtungen die folgenden Schritte ausführt:
Steuern der Ströme in Normalrichtung, die durch die jeweiligen mehreren lichtemittierenden Elemente (51) fließen, derart, dass die Lichtempfangssignale, die den Lichtemissionspegeln der jeweiligen lichtemittierenden Elemente entsprechen und von dem Lichtempfangselement (52) in der Halbleiterlaser-Anordnung (13) ausgegeben werden, und die Lichtemissionspegel-Angabesignale unter Verwendung einer Stromsteuervorrichtung jeweils aneinander angeglichen werden;
Umschalten der mehreren Halbleiterlaser-Ansteuerungsvorrichtungen zu irgendeiner von ihnen als eine negative Rückkopplungsschleife, an die das Lichtempfangssignal von dem Lichtempfangselement in der Halbleiterlaser-Anordnung ausgegeben wird, unter Verwendung einer Umschalt-Schaltvorrichtung;
jeweiliges Bestimmen eines Ausgabezeitpunkts zum Ausgeben eines Umschaltsignals zu der Umschalt-Schaltvorrichtung (65, 66, 67, 68, 69) und eines weiteren Ausgabezeitpunkts zum Ausgeben des Steuerstartsignals zu der Stromsteuervorrichtung in den jeweiligen Halbleiterlaser-Ansteuerungsvorrichtungen (61) unter Verwendung einer Ausgabezeitpunkt-Bestimmungsvorrichtung (11);
Detektieren des Halbleiterlaserlichts, wenn in der Hauptabtastrichtung auf dem lichtempfindlichen Organ (43) gestartet wird, und Erzeugen eines Synchronisationsdetektionssignals unter Verwendung eines Synchronisationsdetektors (44);
**gekennzeichnet durch**
Ausgeben von Umschaltsignalen nach dem Verstreichen von Zeitverzögerungsperioden, die wenigstens der oder den funktionalen Verzögerungszeiten der Umschalt-Schaltvorrichtung (65) entsprechen, zu der Umschalt-Schaltvorrichtung (65) und Ausgeben entsprechender Steuerstartsignale zu den Stromsteuervorrichtungen in den Halbleiterlaser-Ansteuerungsvorrichtungen (61), die mit der **durch** die Umschaltoperation der Umschalt-Schaltvorrichtung gebildeten negativen Rückkopplungsschleife verbunden sind, unter Verwendung einer Ausgabeverzögerungsvorrichtung der Ausgabezeitpunkt-Bestimmungsvorrichtung (11); und
Bestimmen der Ausgabezeitpunkte in Übereinstimmung mit dem **durch** den Synchronisationsdetektor (44) erzeugten Synchronisationsdetektionssignal mittels der Ausgabezeitpunkt-Bestimmungsvorrichtung (11).

4. Verfahren zum optischen Schreiben des Bildes nach Anspruch 3, das ferner den folgenden Schritt umfasst:
Stoppen der Ausgabe des Umschaltsignals zu der Umschalt-Schaltvorrichtung, nachdem die Steueroperation unter Verwendung jener Stromsteuervorrichtung in der Halbleiterlaser-Ansteuerungsvorrichtung unter den Stromsteuervorrichtungen in den jeweiligen Halbleiterlaser-Ansteuerungsvorrichtungen, die mit der durch die Umschaltoperation der Umschalt-Schaltvorrichtung gebildeten negativen Rückkopplungsschleife verbunden ist, beendet worden ist.

## Revendications

1. Dispositif d'écriture optique à faisceaux multiples comprenant :
un réseau de lasers à semi-conducteurs (13) comprenant plusieurs éléments d'émission de lumière (51) et un seul élément de réception de lumière (52) ; et
une pluralité de dispositifs de contrôle de commande de laser à semi-conducteurs (61) commandant respectivement et simultanément ladite pluralité d'éléments d'émission de lumière (51) dans ledit réseau de lasers à semi-conducteurs (13) et amenant de ce fait lesdits éléments d'émission de lumière à effectuer une opération d'écriture optique simultanément pour chacune d'une pluralité de lignes,
dans lequel chacun de ladite pluralité de dispositifs de contrôle de commande de laser à semi-conducteurs comprend :
un dispositif de contrôle de courant (60, 62) contrôlant les courants directs circulant à travers ladite pluralité d'éléments d'émission de lumière (51) respectifs de sorte que des signaux de réception de lumière qui correspondent aux niveaux d'émission de lumière desdits éléments d'émission de lumière respectifs et qui sont délivrés par ledit élément de réception de lumière (52) dans ledit réseau de lasers à semi-conducteurs (13) et des signaux de désignation de niveau d'émission de lumière deviennent respectivement égaux les uns aux autres ;
dans lequel ledit dispositif d'écriture optique comprend en outre :
un dispositif de commutation (65, 66, 67, 68, 69) capable de commuter ladite pluralité de dispositifs de contrôle de commande de laser à semi-conducteurs vers l'un ou l'autre de ceux-ci en tant que boucle de rétroaction négative, auquel le signal de réception de lumière est appliqué par ledit élément de réception de lumière (52) dans ledit réseau de lasers à semi-conducteurs ; et
un dispositif de détermination de synchronisation de sortie (11) déterminant respectivement une synchronisation de sortie pour appliquer un signal de commutation audit dispositif de commutation (65, 66, 67, 68, 69) et une autre synchronisation de sortie pour appliquer le signal de début de contrôle audit dispositif de contrôle de courant dans lesdits dispositifs de contrôle de commande de laser à semi-conducteurs (61) respectifs ;
un détecteur de synchronisation (44) détectant la lumière des lasers à semi-conducteurs lors d'un démarrage dans la direction de balayage principale sur l'élément photosensible (43), et générant un signal de détection de synchronisation ;
**caractérisé en ce que**
ledit dispositif de détermination de synchronisation de sortie (11) comprend en outre :
un dispositif de retard de sortie qui est configuré pour délivrer des signaux de commutation, après que des périodes de retard correspondant au moins au temps ou aux temps de retard de fonctionnement dudit dispositif de commutation (65) se sont écoulées, audit dispositif de commutation (65) et pour appliquer des signaux de début de contrôle correspondants auxdits dispositifs de contrôle de courant dans lesdits dispositifs de contrôle de commande de laser à semi-conducteurs (61) connectés à ladite boucle de rétroaction négative formée par l'opération de commutation dudit dispositif de commutation, et
dans lequel ledit dispositif de détermination de synchronisation de sortie (11) est configuré pour déterminer les synchronisations de sortie conformément au signal de détection de synchronisation généré par ledit détecteur de synchronisation (44).

2. Dispositif d'écriture optique selon la revendication 1, dans lequel ledit dispositif de détermination de synchronisation de sortie (11) comprend en outre :
un dispositif d'arrêt de sortie arrêtant l'application du signal de commutation audit dispositif de commutation (65, 66, 67, 68, 69), à la fin de l'opération de contrôle en utilisant ledit dispositif de contrôle de courant (60, 62) dans ledit dispositif de contrôle de commande de laser à semi-conducteurs (61) connecté à la boucle de rétroaction négative formée par l'opération de commutation dudit dispositif de commutation parmi lesdits dispositifs de contrôle de courant dans lesdits dispositifs de contrôle de commande de laser à semi-conducteurs respectifs.

3. Procédé d'écriture d'une image avec de multiples faisceaux optiques, consistant à :
préparer un réseau de lasers à semi-conducteurs (13) comprenant plusieurs éléments d'émission de lumière (51) et un seul élément de réception de lumière (52) ; et
commander respectivement et simultanément ladite pluralité d'éléments d'émission de lumière (51) dans ledit réseau de lasers à semi-conducteurs (13) et amener de ce fait lesdits éléments d'émission de lumière à effectuer une opération d'écriture optique simultanément pour chacune d'une pluralité de lignes, en utilisant plusieurs dispositifs de contrôle de commande de laser à semi-conducteurs (61) ;
dans lequel chacun de ladite pluralité de dispositifs de contrôle de commande de laser à semi-conducteurs effectue les étapes consistant à :
contrôler les courants directs circulant à travers ladite pluralité d'éléments d'émission de lumière (51) respectifs de sorte que les signaux de réception de lumière, qui correspondent aux niveaux d'émission de lumière desdits éléments d'émission de lumière respectifs et qui sont délivrés par ledit élément de réception de lumière (52) dans ledit réseau de lasers à semi-conducteurs (13), et les signaux de désignation de niveau d'émission de lumière deviennent respectivement égaux les uns aux autres en utilisant un dispositif de contrôle de courant ;
commuter ladite pluralité de dispositifs de contrôle de commande de laser à semi-conducteurs vers l'un ou l'autre de ceux-ci en tant que boucle de rétroaction négative, auquel le signal de réception de lumière est appliqué par ledit élément de réception de lumière dans ledit réseau de lasers à semi-conducteurs en utilisant un dispositif de commutation ;
déterminer respectivement une synchronisation de sortie pour appliquer un signal de commutation audit dispositif de commutation (65, 66, 67, 68, 69) et une autre synchronisation de sortie pour appliquer le signal de début de contrôle audit dispositif de contrôle de courant dans lesdits dispositifs de contrôle de commande de laser à semi-conducteurs (61) respectifs en utilisant un dispositif de détermination de synchronisation de sortie (11) ;
détecter la lumière des lasers à semi-conducteurs lors d'un démarrage dans la direction de balayage principale sur l'élément photosensible (43), et générer un signal de détection de synchronisation en utilisant un détecteur de synchronisation (44) ;
**caractérisé par**
l'application de signaux de commutation, après que des périodes de retard correspondant au moins au temps ou aux temps de retard de fonctionnement dudit dispositif de commutation (65) se sont écoulées, audit dispositif de commutation (65) et l'application de signaux de début de contrôle correspondants auxdits dispositifs de contrôle de courant dans lesdits dispositifs de contrôle de commande de laser à semi-conducteurs (61) connectés à ladite boucle de rétroaction négative formée par l'opération de commutation dudit dispositif de commutation en utilisant un dispositif de retard de sortie dudit dispositif de détermination de synchronisation de sortie (11), et
la détermination des synchronisations de sortie conformément au signal de détection de synchronisation généré par ledit détecteur de synchronisation (44) au moyen dudit dispositif de détermination de synchronisation de sortie (11).

4. Procédé d'écriture optique d'image selon la revendication 3, comprenant en outre l'étape consistant à :
arrêter l'application du signal de commutation audit dispositif de commutation, à la fin de l'opération de contrôle en utilisant ledit dispositif de contrôle de courant dans ledit dispositif de contrôle de commande de laser à semi-conducteurs connecté à la boucle de rétroaction négative formée par l'opération de commutation dudit dispositif de commutation parmi lesdits dispositifs de contrôle de courant dans lesdits dispositifs de contrôle de commande de laser à semi-conducteurs respectifs.
